(19) Europäisches Patentamt
European Patent Office
Office européen des brevets

(11) **EP 3 948 250 B1**

(12) **EUROPÄISCHE PATENTSCHRIFT**

(45) Veröffentlichungstag und Bekanntmachung des Hinweises auf die Patenterteilung:
**13.12.2023  Patentblatt 2023/50**

(21) Anmeldenummer: **20714520.2**

(22) Anmeldetag: **24.03.2020**

(51) Internationale Patentklassifikation (IPC):
**G01N 27/406** $^{(2006.01)}$     **G01N 27/416** $^{(2006.01)}$
**G01N 27/417** $^{(2006.01)}$

(52) Gemeinsame Patentklassifikation (CPC):
**G01N 27/4065; G01N 27/4163; G01N 27/4175**

(86) Internationale Anmeldenummer:
**PCT/EP2020/058052**

(87) Internationale Veröffentlichungsnummer:
**WO 2020/193496 (01.10.2020 Gazette 2020/40)**

(54) **VERFAHREN ZUR DIAGNOSE VON ABGASSENSOREN**

METHOD OF CHECKING EXHAUST GAS SENSORS

PROCEDE DE CONTROLE DE GAZ D'ECHAPPEMENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.03.2019   DE 102019204219**

(43) Veröffentlichungstag der Anmeldung:
**09.02.2022   Patentblatt 2022/06**

(73) Patentinhaber: **Robert Bosch GmbH**
**70442 Stuttgart (DE)**

(72) Erfinder:
• **LEDERMANN, Bernhard**
  **71263 Weil Der Stadt (DE)**

• **BEVOT, Claudius**
  **70197 Stuttgart (DE)**
• **KREMER, Stefan**
  **70825 Korntal-Muenchingen (DE)**
• **KAYA, Oemer**
  **97070 Wuerzburg (DE)**
• **DITTMER-GOBELJIC, Danka**
  **70191 Stuttgart (DE)**

(56) Entgegenhaltungen:
**WO-A1-2015/022278     DE-A1-102010 000 663**
**DE-A1-102011 077 171     US-A1- 2013 219 984**

**Beschreibung**

Stand der Technik

Aus der DE 10 2010 000 663 A1 ist bereits eine Auswerte- und Steuereinheit bekannt, die als ASIC ausgebildet ist. Sie dient dem Betrieb einer Breitband-Lambdasonde, die elektrische Leitungen aufweist, wobei die Auswerte- und Steuereinheit elektrische Anschlüsse zur elektrischen Verbindung mit den elektrischen Leitungen der Breitbandlambdasonde aufweist und den elektrischen Anschlüssen jeweils ein elektrischer Schalter zugeordnet ist, über den der jeweilige Anschluss mit Masse verbindbar ist.

Eine weitere Auswerte- und Steuereinheit ist aus der DE 10 2011 077 171 A1 bekannt.

Vorteile der Erfindung

Die vorliegende Erfindung beruht auf der Überlegung der Erfinder, dass die aus dem genannten Stand der Technik grundsätzlich bereits bekannten Schalter im Fehlerfall hohen elektrischen Belastungen ausgesetzt sein können. Beispielsweise können die Schalter im Fall eines Kurzschlusses einer Leitung der Lambdasonde mit einer Versorgungsspannung der vollen Versorgungsspannung und den daraus resultierenden Strömen ausgesetzt sein. Die im Fehlerfall an dem jeweiligen Anschluss maximal zu erwartende Kurzschluss-Spannung kann in diesem Fall durch die Versorgungsspannung gegeben sein.

Der Wert der Spannung, die hier als die im Fehlerfall an dem jeweiligen Anschluss maximal zu erwartende Kurzschluss-Spannung bezeichnet wird, beträgt 16V.

Um ohne weitere hardware- oder softwareseitigen Schutzmechanismen sicherzustellen, dass in derartigen Fehlerfällen an den Leitungen der Breitbandlambda-Sonde keine Schäden der Auswerte- und Steuereinheit resultieren, und um überdies auch im Fehlerfall ein Verfahren zur Diagnose der elektrischen Leitungen einer Breitbandlambdasonde zu ermöglichen, ist insbesondere vorgesehen, dass der jeweilige Schalter spannungsfest gegen die im Fehlerfall an dem jeweiligen Anschluss maximal zu erwartende Kurzschluss-Spannung ist.

Unter der Spannungsfestigkeit eines Bauteils gegen eine Spannung wird hier die Eigenschaft des Bauteils verstanden, dieser Spannung über mehrere Sekunden, ohne Schädigung aussetzbar zu sein. Insbesondere bei hoher Miniaturisierung, beispielsweise bei Ausführung des Bauteils als Teil einer als ASIC ausgeführten Auswerte- und Steuereinheit, setzt dies entsprechende konstruktive Maßnahmen voraus, beispielsweise ausreichende Isolierungen und/oder Abschirmungen.

Um im Fehlerfall die gewünschten Diagnosen durchführen zu können, ist es bevorzugt, dass der jeweilige Schalter als niederohmiger Schalter ausgeführt ist, also im geschlossenen Zustand insbesondere einen Durchgangswiderstand hat, der nicht größer ist als der Innenwiderstand der elektrochemischen Zellen der Breitband-Lambdasonde bei Betriebstemperatur und/oder insbesondere einen Durchgangswiderstand hat, der nicht größer ist als 100 Ohm.

Erfindungsgemäß ist es vorgesehen, dass jeder Schalter individuell mit einem elektrischen Potential verbindbar ist, welches zwei verschiedene definierte Werte annehmen kann. Eines der definierten elektrischen Potentiale kann das Massenpotential, beispielsweise 0V, sein, oder eine virtuelle Masse, die auf einem anderen Potential liegt. Es ist weiter vorgesehen, dass durch entsprechende Spannungsquellen und/oder entsprechende Spannungsteiler verschiedene Potenziale zu Verfügung gestellt werden.

Insbesondere ist vorgesehen, dass zwischen dem jeweiligen Schalter und dem definierten elektrischen Potenzial ein Spannungsteiler vorgesehen ist, durch den im Fehlerfall eine Teilspannung der maximal zu erwartenden Kurzschluss-Spannung abgreifbar ist, die innerhalb des Messbereichs eines Messsystems, beispielsweise eines ADCs, der Auswerte- und Steuereinheit liegt. Auf diese Weise kann eine gezielte Diagnose der Breitband-Lambdasonde im Fehlerfall vorgenommen werden.

Der Messbereich des Messsystems, beispielsweise des ADCs, der Auswerte- und Steuereinheit kann beispielsweise 0V - 3,6V oder beispielsweise -5V - +5 V betragen.

Der Spannungsteiler kann also beispielsweise die maximal zu erwartende Kurzschluss-Spannung auf die obere Grenze des Messbereichs des Messsystems herunterteilen. Bei einer maximal zu erwartenden Kurzschluss-Spannung von 36V und einer oberen Grenze des Messbereichs des Messsystems von 3,6V kann also beispielsweise ein Spannungsteiler vorgesehen werden, der die anliegende Spannung im Verhältnis 9 zu 1 teilt.

Vorteilhafterweise kann ein einziger Spannungsteiler vorgesehen sein, der mit sämtlichen Schaltern verbunden ist. Alternativ kann jedem Schalter ein individueller Spannungsteiler zugeordnet sein.

Es ist vorteilhaft, wenn die Anschlüsse über die Schalter miteinander verbindbar, insbesondere kurzschließbar sind. Die Leitungen der Breitband-Lambdasonde können dann auf ein gemeinsames elektrisches Potenzial gelegt werden, wodurch die Breitbandlambdasonde geschützt wird, insbesondere wenn die Schalter nur noch zum Zwecke der Diagnose geöffnet werden und ansonsten geschlossen bleiben.

Ist ferner zwischen den Schaltern und dem definierten elektrischen Potenzial ein weiterer Schalter angeordnet, kann dieser im Fehlerfall geöffnet werden, sodass ein Stromfluss durch die Breitbandlambdasonde zu dem definierten elektrischen Potenzial dann unterbleibt.

Es kann vorgehen sein, dass zur Realisierung des Spannungsteilers zwei ohmsche Widerstände zwischen dem jeweiligen Schalter und dem definierten elektrischen Potenzial in Reihe geschaltet sind. Das Verhältnis der Widerstandswerte der ohmschen Widerstände bestimmt dann das Verhältnis, in dem die am Spannungsteiler anliegende Spannung geteilt wird. Bei einer maximal zu erwartenden Kurzschluss-Spannung von 36V gegen das definierte elektrische Potenzial und einer oberen Grenze des Messbereichs des Messsystems von 3,6V gegen das definierte Potenzial können also beispielsweise ohmsche Widerstände von 3,24 kOhm und 360 Ohm gewählt werden, wenn maximal 10mA fließen sollen.

In einer sehr bevorzugten Weiterbildung der Erfindung ist vorgesehen, dass auch der dem Schalter zugewandte ohmsche Widerstand des Spannungsteilers spannungsfest gegen die im Fehlerfall an den Anschlüssen maximal zu erwartende Kurzschluss-Spannung ist.

Dabei kann vorgesehen sein, dass die Spannungsfestigkeit des von dem Schalter abgewandten ohmschen Widerstands des Spannungsteilers nicht über die Spannungsfestigkeit des Messsystems hinausgeht.

Das erfindungsgemäße Verfahren erfolgt mit einer Auswerte- und Steuereinheit, bei der das definierte elektrische Potenzial zwei verschiedene definierte Werte annehmen kann. Es ist dabei vorgesehen, dass für jede Anschlussleitung ein erster Strom gemessen wird, während das definierte Potenzial einen ersten Wert hat, und ein zweiter Strom gemessen wird, während das definierte Potenzial einen zweiten Wert hat.

Die verschiedenen definierten Werte des definierten elektrischen Potenzials können beispielsweise über einstellbare Spannungsteiler generiert werden.

Gemäß der Annahme, dass die elektrischen Verbindungen der Lambdasonde zueinander hochohmig sind, erfolgt die Rechnung gemäß der Formel:

$$R_{SC} = [R_{ref} * (I_1 - I_2 - I_{0,1} + I_{0,2}) + V_{SET,1} - V_{SET,2}] / (I_2 - I_1 - I_{0,2} + I_{0,1}).$$

Dabei ist:

| | |
|---|---|
| $R_{SC}$: | der Kurzschlusswiderstand, |
| $R_{ref}$: | der Gesamtwiderstand zwischen definiertem Potenzial und dem Schalter, |
| $I_1, I_2$: | der dem Anschluss zugeordnete Strom bei Anliegen des ersten bzw. zweiten Potenzials bei geschlossenem Schalter, |
| $I_{01}, I_{02}$: | der dem Anschluss zugeordnete Strom bei Anliegen des ersten bzw. zweiten Potenzials bei offenem Schalter, |
| $V_{SET1}, V_{SET2}$: | das erste bzw. zweite Potenzial. |

Unter der Annahme, dass die elektrischen Leitungen der Lambdasonde zueinander hochohmig sind, erfolgt die Rechnung gemäß der Formel:

$$V_{SC} = 1/2 * [R_{SC} * (I_1 + I_2 + I_{0,1} + I_{0,2}) + R_{ref} * (I_1 + I_2) + V_{SET,1} + V_{SET,2}].$$

Dabei ist:

| | |
|---|---|
| $V_{SC}$: | die Kurzschlussspannung. |

Es kann grundsätzlich für jede Anschlussleitung ein Kurzschlusswiderstand und eine Kurzschlussspannung durch Rechnung bestimmt werden. Sind die elektrischen Leitungen der Lambdasonde zueinander nicht hochohmig aber sind die Innenwiderstände der Lambdasonde dennoch bekannt oder werden bestimmte Werte angenommen, erfolgt die Berechnung der Kurzschlusswiderstände und die Berechnung der Kurzschlussspannungen durch Lösen der sich ergebenden linearen Gleichungssysteme.

Vorteilhafterweise ist vorgesehen, dass auf einen Kurzschluss geschlossen wird, wenn zumindest ein ermittelter Kurzschlusswiderstand einen vorgegebenen Schwellwert unterschreitet und der Kurzschluss der Leitung zugeordnet wird, die mit dem Anschluss verbunden ist, an dem der kleinste Kurzschlusswiderstand aufgetreten ist.

Es kann vorgesehen sein, dass in dem Fall, in dem der kleinste Kurzschlusswiderstand nicht mehr als ein additiver oder multiplikativer Schwellwert von dem zweitkleinsten Kurzschlusswiderstand verschieden ist, die Messungen nach einer Wartezeit, in der die Breitband-Lambdasonde sich abkühlt, wiederholt wird. Durch die Abkühlung kann erwartet werden, dass der Kurzschlusswiderstand an den Leitungen, an denen kein Kurzschluss vorliegt, zunimmt. Dann kann eindeutig bestimmt werden, an welcher Leitung der Kurzschluss tatsächlich vorliegt.

Aus der Kenntnis des Diagnoseergebnisses können geeignete technische Maßnahmen abgeleitet werden. Beispielsweise kann vorgesehen sein, dass die Information über das Vorliegen eines Kurzschlusses; insbesondere die Tatsache eines Kurzschlusses an sich, die Leitung an der der Kurzschluss festgestellt wurde, das Kurzschlusspotenzial und/oder der Kurzschlusswiderstand; in einem nichtflüchtigen Datenspeicher abgelegt werden, beispielsweise durch einen Eintrag in einem Fehlerspeicher der Auswerte- und Steuereinheit und/oder in einem Fehlerspeicher eines mit der Auswerte- und Steuereinheit verbundenen Steuergeräts.

Zeichnung

Figur 1    zeigt eine Auswerte- und Steuereinheit zum Betreiben einer Breitband-Lambdasonde (kein erfindungsgemäßes Ausführbeispiel)..

Figur 2    zeigt ein Flussdiagramm eines Diagnoseverfahrens mit der Auswerte- und Steuereinheit gemäß Figur 1.

Figur 3    zeigt ein erfindungsgemäßes Ausführungsbeispiel einer Auswerte- und Steuereinheit zum Betreiben einer Breitband-Lambdasonde.

Figur 4    zeigt ein Flussdiagramm eines Diagnoseverfahrens mit der Auswerte- und Steuereinheit gemäß Figur 3.

Beschreibung der Ausführungsbeispiele

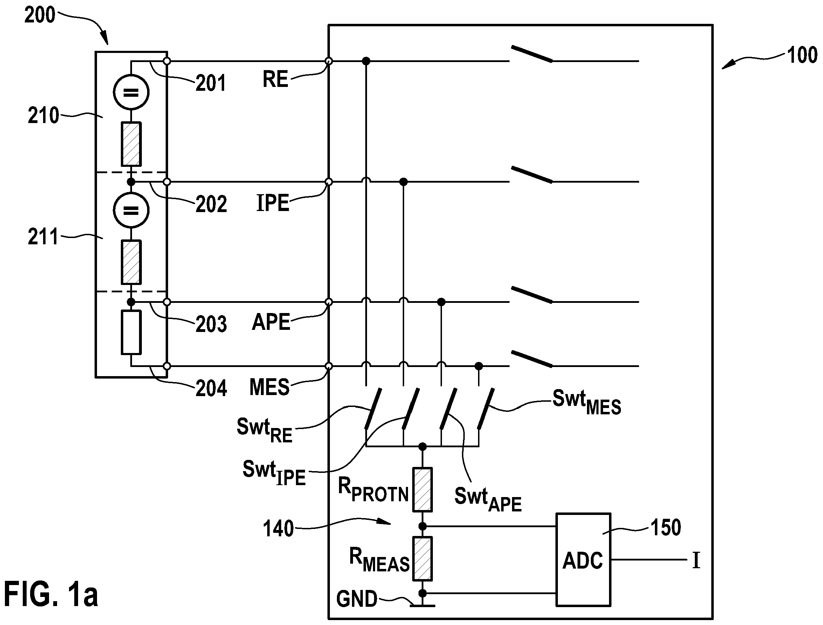

Die Figur 1a zeigt eine Auswerte- und Steuereinheit 100 zum Betreiben einer Breitband-Lambdasonde 200 (kein erfindungsgemäßes Ausführbeispiel). Die Auswerte- und Steuereinheit 100 ist über vier Anschlüsse RE, IPE, APE, MES mit elektrischen Leitungen 201, 202, 203, 204 einer Breitband-Lambdasonde 200 verbunden. Diese Leitungen führen zu elektrochemischen Zellen 210, 211 der Breitband-Lambdasonde 200. Mögliche Details der Breitband-Lambdasonde 200 sind beispielsweise in der DE 10 2011 007 068 A1 dargestellt.

Die Auswerte- und Steuereinheit 100 ist nur insofern gezeigt, wie es für das Verständnis der vorliegenden Erfindung erforderlich ist. Mögliche Details der Auswerte- und Steuereinheit 100 sind beispielsweise in der Patentschrift EP 2 277 035 B1 dargestellt.

Die Auswerte- und Steuereinheit 100 verfügt im Beispiel über einen Anschluss an Masse GND, mit dem jeder der Anschlüsse RE, IPE, APE, MES individuell über jeweils einen spannungsfesten Schalter $Swt_{RE}$, $Swt_{IPE}$, $Swt_{APE}$, $Swt_{MES}$ und über einen gemeinsamen Spannungsteiler 140 verbunden ist.

Der gemeinsame Spannungsteiler 140 besteht im Beispiel aus zwei in Reihe geschalteten ohmschen Widerständen R_Protn und R_Meas. Ihre Widerstandswerte betragen in diesem Beispiel R_Protn = 3,24 kOhm und R_Meas = 360 Ohm.

Die über dem Widerstand R_Meas abfallende Spannung U ist durch einen ADC 150 der Auswerte- und Steuereinheit 100 messbar. Durch Division mit R_Meas ergibt sich der durch den Spannungsteiler 140 fließende Strom I.

Beispielsweise zwischen dem Widerstand R_Meas und GND kann ein weiterer Schalter vorgesehen sein (in der Figur 1a nicht gezeichnet). Wird er im Fehlerfall geöffnet, bewirkt dies, dass ein Stromfluss durch die Breitbandlambdasonde 200 nach GND unterbleibt.

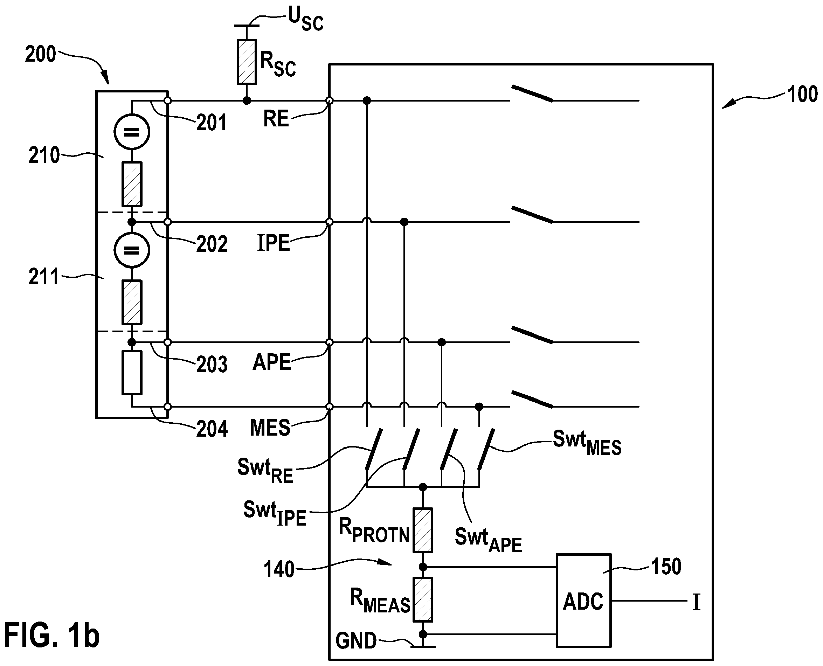

In der Figur 1b ist der Fehlerfall eines niederohmigen Kurzschlusses der Leitung 201 an eine Versorgungsspannung von 36 V gezeigt, indem über die Leitung 201 der Breitband-Lambdasonde 200 an dem Anschluss RE der Auswerte- und Steuereinheit 100 die Kurzschlussspannung U_SC = 36V über den Kurzschlusswiderstand R_SC = 0 Ohm dargestellt ist.

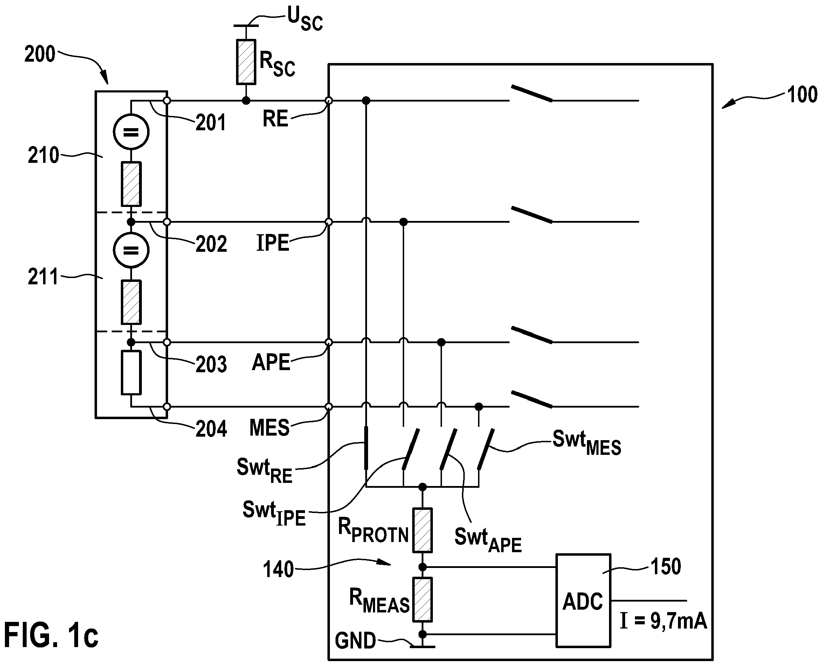

In der Figur 1c wurde der dem Anschluss RE zugeordnete niederohmige Schalter $Swt_{RE}$ (Innenwiderstand $R_{SwtRE}$ = 100 Ohm) geschlossen, sodass ein Strom I von 9,7 mA von der Leitung 201 über den Anschluss RE und den Spannungsteiler 140 zur Masse GND fließt. Am Messwiderstand R_Meas fällt folglich eine Spannung von 3,502 V ab, die durch den ADC 150 digitalisiert wird.

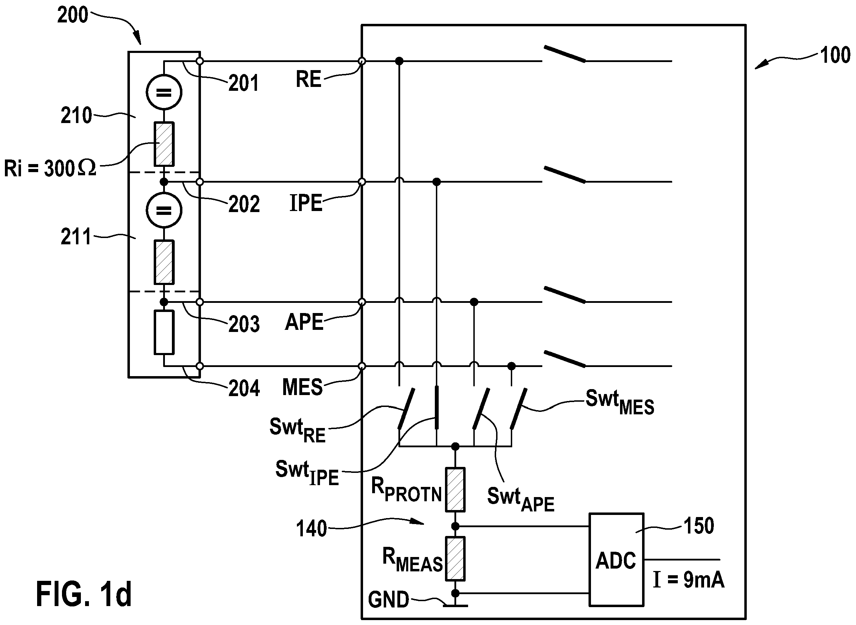

In der Figur 1d wurde der dem Anschluss RE zugeordnete niederohmige Schalter $Swt_{RE}$ geöffnet und stattdessen der dem Anschluss IPE zugeordnete niederohmige Schalter $Swt_{IPE}$ (Innenwiderstand $R_{SwtIPE}$ = 100 Ohm) geschlossen. Da der Innenwiderstand der Breitband-Lambdasonde zwischen den Leitungen 201 und 202 im heißen Zustand Ri = 300 Ohm beträgt, fließt nun ein Strom I über den Spannungsteiler 140 zur Masse GND, der 9 mA beträgt. Entsprechend fällt am Messwiderstand R_Meas eine Spannung von 3,240 V ab, die durch den ADC 150 digitalisiert wird.

Ähnliche Ströme und Spannungen ergeben sich, wenn anstelle des Schalters $Swt_{IPE}$ der Schalter $Swt_{APE}$ geschlossen wird oder wenn der Schalter $Swt_{MES}$ geschlossen wird.

Für den Anschluss RE wurde eindeutig der höchste Strom I ermittelt. Da vorab bekannt war, dass an diesem Anschluss mit 36V ein unzulässig hohes Potenzial anliegt, also bekannt war, dass ein Kurzschluss grundsätzlich vorliegt, wird darauf geschlossen, dass der Kurzschluss an der mit dem Anschluss RE verbundenen Leitung 201 der Breitband-Lambdasonde 200 vorliegt.

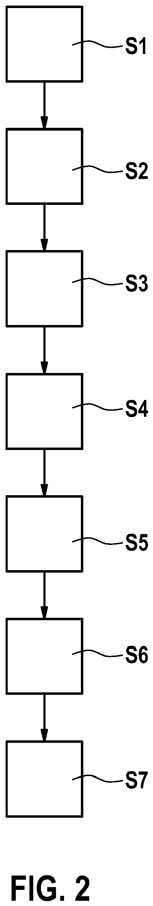

Das beispielhafte Verfahren gemäß der mit Bezug auf die Figur 1 geschilderten Vorrichtung ist in der Figur 2 als Flussdiagramm dargestellt (kein erfindungsgemäßes Ausführbeispiel).:

- Verfahrensschritt S1: Schließen des Schalters $Swt_{RE}$
- Verfahrensschritt S2: Messen des Stroms $I_{RE}$ der nachfolgend durch den Spannungsteiler 140 an Masse GND fließt
- Verfahrensschritt S3: Öffnen des Schalters $Swt_{RE}$ und Schließen des Schalters $Swt_{IPE}$
- Verfahrensschritt S4: Messen des Stroms $I_{IPE}$ der nachfolgend durch den Spannungsteiler 140 an Masse GND fließt
- Verfahrensschritt S5: Feststellen welcher der Ströme $I_{RE}$, $I_{IPE}$ größer ist
- Verfahrensschritt S6: Zuordnen des Kurzschlusses zu der Leitung 201, die mit dem Anschluss RE verbunden ist, durch den der größere Strom floss.
- Verfahrensschritt S7: Ablegen der gewonnenen Information, dass an der Leitung 201 ein Kurzschluss vorliegt, in einem Fehlerspeicher eines mit der Auswerte- und Steuereinheit 100 verbundenen Steuergeräts.

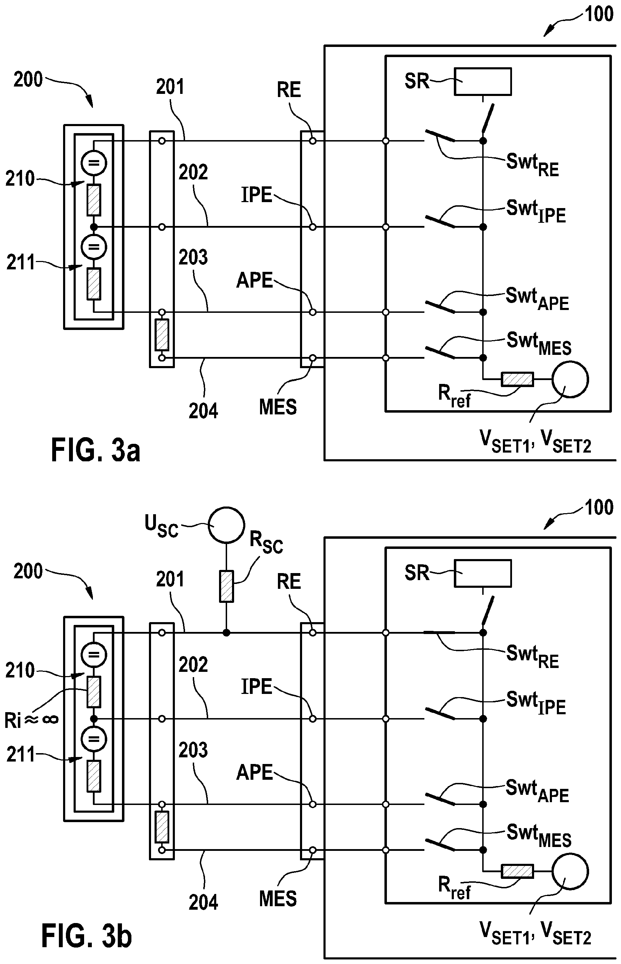

Die Figur 3a zeigt ein erfindungsgemäßes Ausführungsbeispiel einer Auswerte- und Steuereinheit 100 zum Betreiben einer Breitband-Lambdasonde 200. Die Auswerte- und Steuereinheit 100 ist über vier Anschlüsse RE, IPE, APE, MES mit elektrischen Leitungen 201, 202, 203, 204 einer Breitband-Lambdasonde 200 verbunden, die so kalt ist, dass zwischen je zwei der Leitungen 201, 202, 203, 204 ein sehr hoher Innenwiderstand $R_i$ besteht, beispielsweise 1 MOhm. Diese Leitungen führen zu elektrochemischen Zellen 210, 211 der Breitband-Lambdasonde 200. Mögliche Details der Breitband-Lambdasonde 200 sind beispielsweise in der DE 10 2011 007 068 A1 dargestellt.

Die Auswerte- und Steuereinheit 100 ist nur insofern gezeigt, wie es für das Verständnis der vorliegenden Erfindung erforderlich ist. Mögliche Details der Auswerte- und Steuereinheit 100 sind beispielsweise in der Patentschrift EP 2 277 035 B1 dargestellt.

Die Auswerte- und Steuereinheit 100 verfügt im Beispiel über einen Anschluss an ein definiertes Potenzial, das die Werte $V_{SET1}$ = 2V und $V_{SET2}$ = 10V annehmen kann. Mit diesem definierten Potenzial ist jeder der Anschlüsse RE, IPE, APE, MES individuell über jeweils einen spannungsfesten Schalter $Swt_{RE}$, $Swt_{IPE}$, $Swt_{APE}$, $Swt_{MES}$, und über einen gemeinsamen Referenzwiderstand $R_{Ref}$ = 100 Ohm verbindbar. Ferner kann auf der den Anschlüssen RE, IPE, APE, MES abgewandten Seite der Schalter $Swt_{RE}$, $Swt_{IPE}$, $Swt_{APE}$, $Swt_{MES}$ eine Stromquelle SR zugeschaltet werden. Im Beispiel ist sie allerdings durch einen geöffneten Schalter abgetrennt.

In der Figur 3b ist der Fehlerfall eines niederohmigen Kurzschlusses der Leitung 201 an eine Versorgungsspannung gezeigt, indem über die Leitung 201 der Breitband-Lambdasonde 200 an dem Anschluss RE der Auswerte- und Steuereinheit 100 die Kurzschlussspannung Usc über den Kurzschlusswiderstand Rsc dargestellt ist.

Bei dem definierten Potenzial $V_{SET1}$ = 2V wird vor dem Schließen des Schalters $Swt_{RE}$ ein Strom $I_{0,1}$ durch $R_{Ref}$ von 0mA festgestellt und nach Schließen des Schalters $Swt_{RE}$ ein Strom $I_1$ durch $R_{Ref}$ von 100mA festgestellt.

Bei dem definierten Potenzial $V_{SET2}$ = 10V wird vor dem Schließen des Schalters $Swt_{RE}$ ein Strom $I_{0,2}$ durch $R_{Ref}$ von 0mA festgestellt und nach Schließen des Schalters $Swt_{RE}$ ein Strom $I_2$ durch $R_{Ref}$ von 20 mA festgestellt.

Durch Anwendung der Formeln

$$R_{SC}=[R_{ref}*(I_1-I_2-I_{0,1}+I_{0,2})+V_{SET,1}-V_{SET,2}]/(I_2-I_1-I_{0,2}+I_{0,1}),$$

$$Vsc=1/2*[R_{SC}*(I_1+I_2+I_{0,1}+I_{0,2})+R_{ref}*(I_1+I_2)+V_{SET,1}+V_{SET,2}],$$

erhält man: Rsc = 0 Ohm, Vsc = 12 V.

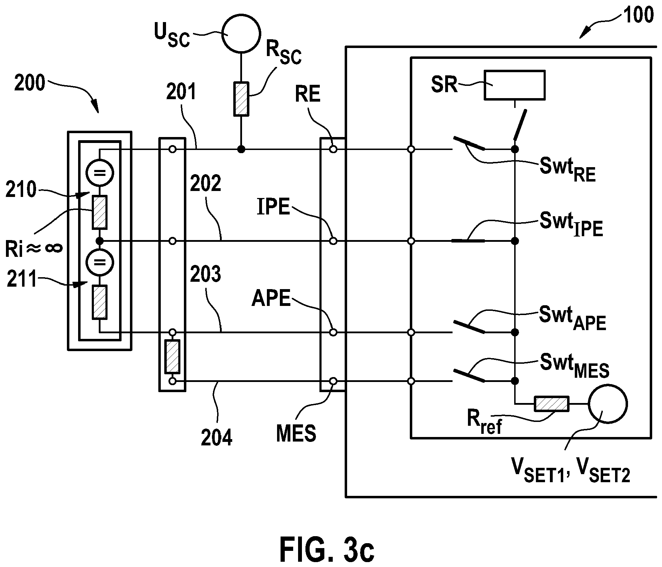

In der Figur 3c wurde der dem Anschluss RE zugeordnete niederohmige Schalter $SwtR_{RE}$ geöffnet und stattdessen der dem Anschluss IPE zugeordnete niederohmige Schalter $Swt_{IPE}$ geschlossen. Unabhängig davon, ob der Schalter $Swt_{IPE}$ geöffnet oder geschlossen ist und unabhängig vom Wert des definierten Potenzials $V_{SET1}$, $V_{SET2}$, fließt durch den Widerstand $R_{Ref}$ ein Strom vom 0mA.

Durch Anwenden der oben genannten Formeln erhält man die Information, dass mit Hinblick auf die Leitung 202 ein "Kurzschlusswiderstand" Rsc sehr klein ist.

Insgesamt kann geschlossen werden, dass in diesem Beispiel ein sehr niederohmiger Kurzschluss der Leitung 201 gegen eine Kurzschlussspannung von 12V vorliegt.

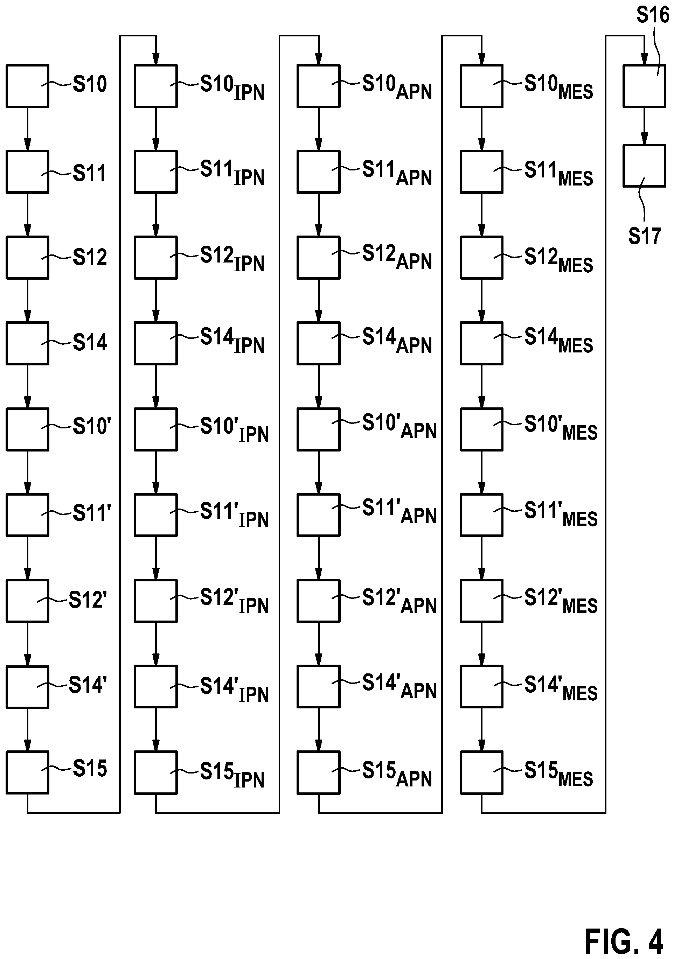

Das beispielhafte Verfahren gemäß der mit Bezug auf die Figur 3 geschilderten Vorrichtung ist in der Figur 4 als Flussdiagramm dargestellt:

Bei $V_{SET\ 1}$:

- Verfahrensschritt S10: Öffnen der Schalter $Swt_{RE}$, $Swt_{IPE}$, $Swt_{APE}$, $Swt_{MES}$

- Verfahrensschritt S11: Messen des Stroms $I_{01}$ der durch den Referenzwiderstand $R_{Ref}$ an das definierte Potenzial fließt
- Verfahrensschritt S12: Schließen des Schalters $Swt_{RE}$
- Verfahrensschritt S14: Messen des Stroms $I_1$ der durch den Referenzwiderstand $R_{Ref}$ an das definierte Potenzial fließt

Bei $V_{SET\,2}$:

- Verfahrensschritt S10': Öffnen der Schalter $Swt_{RE}$, $Swt_{IPE}$, $Swt_{APE}$, $Swt_{MES}$
- Verfahrensschritt S11': Messen des Stroms $I_{01}$ der durch den Referenzwiderstand $R_{Ref}$ an das definierte Potenzial fließt
- Verfahrensschritt S12': Schließen des Schalters $Swt_{RE}$
- Verfahrensschritt S14': Messen des Stroms $I_1$ der durch den Referenzwiderstand $R_{Ref}$ an das definierte Potenzial fließt
- Verfahrensschritt 15: Berechnen des Kurzschlusswiderstandes Rsc und der Kurzschlussspannung Usc für die an dem Anschluss RE Leitung der Breitband-Lambdasonde.

Wiederholen der Schritte S10 bis S14 und S10' bis S14 und S15 für die anderen Anschlüsse IPN, APN und MES. (Verfahrensschritt $S10_{IPN}$ bis $S14_{IPN}$ und $S10'_{IPN}$ bis $S14'_{IPN}$ und $S15_{IPN}$; $S10_{APN}$ bis $S14_{APN}$ und $S10'_{APN}$ bis $S14'_{APN}$ und $S15_{APN}$; $S10_{MES}$ bis $S14_{MES}$ und $S10'_{MEs}$ bis $S14'_{MES}$ und $S15_{MES}$).

- Verfahrensschritt S16: Zuordnen des Kurzschlusses zu der Leitung 201, die mit dem Anschluss RE verbunden ist, für den der kleinste Kurzschlusswiderstand RSC bestimmt wurde.
- Verfahrensschritt S17: Ablegen der gewonnenen Information, dass an der Leitung 201 ein Kurzschluss vorliegt in einem Fehlerspeicher eines mit der Auswerte- und Steuereinheit 100 verbundenen Steuergeräts.

**Patentansprüche**

1. Verfahren zur Diagnose der elektrischen Leitungen (201, 202, 203, 204) einer Breitbandlambdasonde (200), wobei die elektrischen Leitungen (201, 202, 203, 204) der Breitbandlambdasonde (200) jeweils mit einem Anschluss (RE, IPE,APE, MES) einer Auswerte- und Steuereinheit (100) verbunden sind, wobei die Auswerte- und Steuereinheit insbesondere als ASIC ausgebildet ist und zum Betreiben einer Breitband-Lambdasonde (200) dient, welche mindestens zwei elektrische Leitungen (201, 202, 203, 204) aufweist; wobei die Auswerte- und Steuereinheit (100) mindestens zwei elektrische Anschlüsse (RE, IPE,APE, MES) zur elektrischen Verbindung mit den elektrischen Leitungen (201, 202, 203, 204) der Breitbandlambdasonde (200) aufweist, wobei jedem der elektrischen Anschlüsse (RE, IPE,APE, MES) jeweils ein elektrischer Schalter ($Swt_{RE}$, $Swt_{IPE}$, $Swt_{APE}$, $Swt_{MES}$) zugeordnet ist, über den der jeweilige Anschluss (RE, IPE,APE, MES) individuell mit mindestens einem definierten elektrischen Potenzial (GND, $V_{SET1}$, $V_{SET2}$) verbindbar ist, welches zwei verschiedene definierte Werte annehmen kann, wobei der jeweilige Schalter ($Swt_{RE}$, $Swt_{IPE}$, $Swt_{APE}$, $Swt_{MES}$) einer an dem jeweiligen Anschluss (RE, IPE,APE, MES) anliegenden Spannung von 16V über mehrere Sekunden ohne Schädigung aussetzbar ist, wobei das Verfahren vorsieht, dass nacheinander jeweils genau einer der elektrischen Schalter ($Swt_{RE}$, $Swt_{IPE}$, $Swt_{APE}$, $Swt_{MES}$) geschlossen wird, und dass für jede Leitung (201, 202, 203, 204) einer erster Strom ($I_1$) gemessen wird, während das definierte Potenzial (GND, $V_{SET1}$, $V_{SET2}$) einen ersten Wert hat, und ein zweiter Strom ($I_2$) gemessen wird, während das definierte Potenzial (GND, $V_{SET1}$, $V_{SET2}$) einen zweiten Wert hat und dass aus dem Wert des ersten Potenzials und dem Wert des zweiten Potenzials und dem Wert des ersten Stroms und dem Wert des zweiten Stroms, insbesondere basierend auf der Annahme, dass die elektrischen Leitungen (201, 202, 203, 204) der Lambdasonde (200) zueinander hochohmig sind, für jede Leitung (201, 202, 203, 204) ein Kurzschlusswiderstand (Rsc) bestimmt wird.

2. Verfahren nach Anspruch 1, **dadurch gekennzeichnet, dass** aus dem Wert des ersten Potenzials und dem Wert des zweiten Potenzials und dem Wert des ersten Stroms und dem Wert des zweiten Stroms, insbesondere basierend auf der Annahme, dass die elektrischen Leitungen (201, 202, 203, 204) der Lambdasonde zueinander hochohmig sind, für jede Leitung (201, 202, 203, 204) ein Kurzschlusspotenzial (Usc) bestimmt wird.

3. Verfahren nach einem der Ansprüche 1 oder 2, **dadurch gekennzeichnet, dass** auf einen Kurzschluss geschlossen wird, wenn zumindest ein ermittelter Kurzschlusswiderstand (Rsc) einen vorgegebenen Schwellwert unterschreitet und der Kurzschluss der Leitung (201, 202, 203, 204) zugeordnet wird, die mit dem Anschluss (RE, IPE,APE, MES) verbunden ist, an dem der kleinste Kurzschlusswiderstand aufgetreten ist.

**4.** Verfahren nach einem der Ansprüche 1 - 3, **dadurch gekennzeichnet, dass** die Information über das Vorliegen eines Kurzschlusses; insbesondere über die Tatsache eines Kurzschlusses an sich, über die Leitung (201, 202, 203, 204) an der der Kurzschluss festgestellt wurde, über das Kurzschlusspotenzial (Usc) und/oder über den Kurzschlusswiderstand (Rsc); in einem nichtflüchtigen Datenspeicher abgelegt werden, beispielsweise durch einen Eintrag in einem Fehlerspeicher der Auswerte- und Steuereinheit (100) und/oder in einem Fehlerspeicher eines mit der Auswerte- und Steuereinheit (100) verbundenen Steuergeräts.

**Claims**

**1.** Method for diagnosing the electrical lines (201, 202, 203, 204) of a broadband lambda probe (200), wherein the electrical lines (201, 202, 203, 204) of the broadband lambda probe (200) are each connected to a connection (RE, IPE,APE, MES) of an evaluation and control unit (100), wherein the evaluation and control unit is in the form of an ASIC, in particular, and is used to operate a broadband lambda probe (200) having at least two electrical lines (201, 202, 203, 204); wherein the evaluation and control unit (100) has at least two electrical connections (RE, IPE,APE, MES) for electrical connection to the electrical lines (201, 202, 203, 204) of the broadband lambda probe (200), wherein each of the electrical connections (RE, IPE,APE, MES) is respectively assigned an electrical switch ($Swt_{RE}$, $Swt_{IPE}$, $Swt_{APE}$, $Swt_{MES}$) which can be used to individually connect the respective connection (RE, IPE,APE, MES) to at least one defined electrical potential (GND, $V_{SET1}$, $V_{SET2}$) which can assume two different defined values, wherein the respective switch ($Swt_{RE}$, $Swt_{IPE}$, $Swt_{APE}$, $Swt_{MES}$) can be exposed to a voltage of 16 V, which is applied to the respective connection (RE, IPE,APE, MES), for several seconds without damage, wherein the method provides that precisely one of the electrical switches ($Swt_{RE}$, $Swt_{IPE}$, $Swt_{APE}$, $Swt_{MES}$) is closed in succession in each case, and that, for each line (201, 202, 203, 204), a first current ($I_1$) is measured while the defined potential (GND, $V_{SET1}$, $V_{SET2}$) has a first value, and a second current ($I_2$) is measured while the defined potential (GND, $V_{SET1}$, $V_{SET2}$) has a second value, and that a short-circuit resistance (Rsc) is determined for each line (201, 202, 203, 204) from the value of the first potential and the value of the second potential and the value of the first current and the value of the second current, in particular on the basis of the assumption that the electrical lines (201, 202, 203, 204) of the lambda probe (200) have a high impedance with respect to one another.

**2.** Method according to Claim 1, **characterized in that** a short-circuit potential (Usc) is determined for each line (201, 202, 203, 204) from the value of the first potential and the value of the second potential and the value of the first current and the value of the second current, in particular on the basis of the assumption that the electrical lines (201, 202, 203, 204) of the lambda probe have a high impedance with respect to one another.

**3.** Method according to either of Claims 1 and 2, **characterized in that** a short circuit is inferred if at least one determined short-circuit resistance (Rsc) falls below a predefined threshold value, and the short circuit is assigned to that line (201, 202, 203, 204) which is connected to the connection (RE, IPE,APE, MES) at which the lowest short-circuit resistance has occurred.

**4.** Method according to one of Claims 1-3, **characterized in that** the information about the presence of a short circuit, in particular about the fact of a short circuit per se, about the line (201, 202, 203, 204) on which the short circuit was determined, about the short-circuit potential (Usc) and/or about the short-circuit resistance (Rsc), is stored in a non-volatile data memory, for example by way of an entry in an error memory of the evaluation and control unit (100) and/or in an error memory of a control device connected to the evaluation and control unit (100).

**Revendications**

**1.** Procédé permettant de diagnostiquer des lignes électriques (201, 202, 203, 204) d'une sonde lambda à large bande (200), dans lequel les lignes électriques (201, 202, 203, 204) de la sonde lambda à large bande (200) sont respectivement reliées à une borne (RE, IPE, APE, MES) d'une unité d'évaluation et de commande (100), dans lequel l'unité d'évaluation et de commande est réalisée en particulier sous forme d'ASIC et sert à faire fonctionner une sonde lambda à large bande (200) qui présente au moins deux lignes électriques (201, 202, 203, 204) ; dans lequel l'unité d'évaluation et de commande (100) présente au moins deux bornes électriques (RE, IPE, APE, MES) pour la liaison électrique aux lignes électriques (201, 202, 203, 204) de la sonde lambda à large bande (200), dans lequel à chacune des bornes électriques (RE, IPE,APE, MES) est associé respectivement un commutateur électrique ($Swt_{RE}$, $Swt_{IPE}$, $Swt_{APE}$, $Swt_{MES}$) par lequel la borne respective (RE, IPE, APE, MES) peut être reliée individuellement à au moins un potentiel électrique défini (GND, $V_{SET1}$, $V_{SET2}$) qui peut prendre deux valeurs définies différentes, dans lequel le commutateur respectif (Swt$_{RE}$, Swt$_{IPE}$, Swt$_{APE}$, Swt$_{MES}$) peut être soumis sans dommage pendant plusieurs secondes à une tension de 16 V appliquée à la borne respective (RE, IPE, APE, MES), dans lequel le procédé prévoit que successivement, exactement l'un des commutateurs électriques (Swt$_{RE}$, Swt$_{IPE}$, Swt$_{APE}$, Swt$_{MES}$) soit fermé respectivement, et que pour chaque ligne (201, 202, 203, 204) un premier courant (I$_1$) soit mesuré pendant que le potentiel défini (GND, V$_{SET1}$, V$_{SET2}$) présente une première valeur, et qu'un deuxième courant (I$_2$) soit mesuré pendant que le potentiel défini (GND, V$_{SET1}$, V$_{SET2}$) présente une deuxième valeur, et qu'à partir de la valeur du premier potentiel et de la valeur du deuxième potentiel et de la valeur du premier courant et de la valeur du deuxième courant, en particulier en supposant que les lignes électriques (201, 202, 203, 204) de la sonde lambda (200) soient à haute impédance les unes par rapport aux autres, une résistance de court-circuit (Rsc) soit déterminée pour chaque ligne (201, 202, 203, 204).

2. Procédé selon la revendication 1, **caractérisé en ce qu'**un potentiel de court-circuit (Usc) est déterminé pour chaque ligne (201, 202, 203, 204) à partir de la valeur du premier potentiel et de la valeur du deuxième potentiel et de la valeur du premier courant et de la valeur du deuxième courant, en particulier en supposant que les lignes électriques (201, 202, 203, 204) de la sonde lambda soient à haute impédance les unes par rapport aux autres.

3. Procédé selon l'une quelconque des revendications 1 ou 2, **caractérisé en ce qu'**on conclut à un court-circuit si au moins une résistance de court-circuit (Rsc) établie est inférieure à une valeur seuil prédéfinie, et le court-circuit est attribué à la ligne (201, 202, 203, 204) qui est reliée à la borne (RE, IPE, APE, MES) où la plus petite résistance de court-circuit est apparue.

4. Procédé selon l'une quelconque des revendications 1 à 3, **caractérisé en ce que** l'information concernant la présence d'un court-circuit ; en particulier concernant la présence d'un court-circuit en tant que tel par l'intermédiaire de la ligne (201, 202, 203, 204) sur laquelle le court-circuit a été constaté, par l'intermédiaire du potentiel de court-circuit (Usc) et/ou par l'intermédiaire de la résistance de court-circuit (Rsc) ; est sauvegardée dans une mémoire de données non volatile, par exemple par un enregistrement dans une mémoire d'erreurs de l'unité d'évaluation et de commande (100) et/ou dans une mémoire d'erreurs d'un appareil de commande relié à l'unité d'évaluation et de commande (100) .

FIG. 1a

EP 3 948 250 B1

EP 3 948 250 B1

FIG. 1b

FIG. 1c

FIG. 1d

FIG. 2

**FIG. 3a**

**FIG. 3b**

FIG. 3c

**FIG. 4**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102010000663 A1
- DE 102011077171 A1
- DE 102011007068 A1
- EP 2277035 B1